# EUROPEAN PATENT APPLICATION

(11) **EP 1 905 872 A1**
(43) Date of publication of application: **02.04.2008**
(21) Application number: 06766402.9
(22) Date of filing: 25.05.2006
(51) Int. Cl.: C30B 29/06

(54) **QUARTZ GLASS CRUCIBLE FOR PULLING UP OF SILICON SINGLE CRYSTAL AND PROCESS FOR PRODUCING THE QUARTZ GLASS CRUCIBLE**

(30) Priority: 29.06.2005 JP 2005190335
(71) Applicant: Shin-Etsu Handotai Co., Ltd., Tokyo (JP); SHIN-ETSU QUARTZ PRODUCTS CO., LTD., Shinjuku-ku, Tokyo (JP)
(72) Inventor: SAKURADA, Masahiro, c/o Shirakawa R&D Center, Nishishirakawa-gun, Fukushima 961-8061 (JP); SONOKAWA, Susumu, c/o Shirakawa Plant, Nishishirakawa-gun,Fukushima 961-8061 (JP); FUSEGAWA, Izumi, c/o Shirakawa R&D Center, Nishishirakawa-gun, Fukushima 961-8061 (JP); MATSUI, Hiroshi, c/o Takefu Plant, Echizen-shi, Fukui 915-8535 (JP)
(74) Representative: Wibbelmann, Jobst
(86) International application number: PCT/JP2006/310424
(87) International publication number: WO 2007/000864

(57) **Abstract**

The present invention is a quartz glass crucible 5 for pulling a silicon single crystal, comprising at least an outer layer portion 23 being a translucent glass layer containing multiple bubbles in it and an inner layer portion 24 being a transparent quartz glass layer having no bubbles and a smooth surface, formed on the inner surface of the outer layer portion 23, wherein the outer layer portion 23 contains bubbles of 0.1 to 0.3 mm in diameter at the density of 1.5 to 5.0×10⁴ bubbles/cm³. Thus, there are provided a quartz glass crucible for pulling a silicon single crystal, the quartz glass crucible being increased in mechanical strength, making it possible to suppress deformation of a quartz glass crucible for pulling a silicon single crystal during a single crystal pulling process, thereby prevent degradation in yield rate due to dislocation in a single crystal and make the manufacture of a silicon single crystal highly efficient and a method of manufacturing the same quartz glass crucible.

## Description

### TECHNICAL FIELD

The present invention relates to a quartz glass crucible for pulling a silicon single crystal to be used in manufacturing a silicon single crystal by Czochralski method, the quartz glass crucible being high in mechanical strength, being not deformed during a single crystal pulling process, and making it possible to pull a silicon single crystal with high efficiency.

### BACKGROUND ART

Conventionally, a quartz glass crucible has been used as a container for containing raw material silicon melt therein in manufacturing a silicon single crystal by means of Czochralski method. The crucible for pulling a silicon single crystal is generally manufactured by an arc heating rotation-molding method using refined quartz powder obtained by pulverizing and then refining rock crystal or quartz naturally produced as a raw material.

Since a quartz glass crucible manufactured by such a method is manufactured by melting and molding a raw material powder layer formed in the shape of a crucible inside a rotating rotation mold by an inside arc discharge heating process, it has a smooth inner surface and presents a translucent appearance of a layer containing fine bubbles at high density in it. The multi-bubble layer has a function of making uniform a heat transfer from a heater to the inside of a crucible, and in a quartz glass crucible for pulling a silicon single crystal it is very important in order to stabilize a silicon single crystal pulling process to have such a multi-bubble layer structure and have its inner surface made smooth.

Accordingly, a quartz glass crucible of a two-layer structure having a smooth inner surface, having a transparent layer having no bubbles from the inner surface to a predetermined thickness (from about 0.5 mm to 2 mm) as its inner layer and having a multi-bubble layer described above as its outer layer, and a method of manufacturing the quartz glass crucible have been proposed in Japanese Patent Application Laid-Open (Kokai) No. 1-148783. These quartz glass crucibles are very little in generation of roughening on their crucible inner surfaces caused by a silicon single crystal pulling process and also little in generation of cristobalite islands inside the crucible, as a result they have an advantage of enabling to stably perform a silicon single crystal pulling process and improving the productivity of a silicon single crystal.

And in order to stably manufacturing a high-quality silicon single crystal, it is necessary to more improve the purity of a quartz glass crucible, and a quartz glass crucible of a two-layer structure having a transparent layer having substantially no bubbles as its inner layer and having a multi-bubble layer as its outer layer, the inner layer being formed out of high-purity synthetic silica glass of a specified thickness (0.5 mm or more) has been disclosed in Japanese Patent Application Laid-Open (Kokai) No. 5-105577.

On the other hand, a demand for increasing a silicon wafer in diameter is becoming greater from the necessity of increasing the number of chips obtainable from one silicon wafer being a substrate in order to improve the yield rate of VLSI's to suppress an increase in manufacturing cost caused by making the manufacture of VLSI's highly integrated in recent years. And in order to efficiently manufacture a large-diameter silicon single crystal, it is necessary to contain a more amount of polycrystalline silicon being raw material in a quartz glass crucible and the quartz glass crucible has been made larger in size.

At the same time, a component molded out of graphite material forming a furnace body for manufacturing a silicon single crystal has been also made larger in size, and the amount of electric power required for heat generation has been made larger and larger particularly due to making a heater being a heat generating source larger in size. With this, the increase of a thermal load applied to a quartz glass crucible at the time of melting polycrystalline silicon material has become more remarkable.

As a result, even in case of using a quartz glass crucible of a two-layer structure having a multi-bubble layer described above as its outer layer, the quartz glass crucible is softened and deformed during a silicon single crystal manufacturing process, and such phenomena as (1) the bore of the crucible becomes non-circular in shape, (2) the straight body of the quartz glass crucible falls into the silicon melt side, and (3) the straight body of the quartz glass crucible is buckled and so on occur, and thereby have made a great cause for hindering the growth of a silicon single crystal.

### DISCLOSURE OF THE INVENTION

Accordingly, the present invention has been developed in consideration of the above-described problems, and an object of the invention is to provide a quartz glass crucible increased in mechanical strength for pulling a silicon single crystal, making it possible to prevent the degradation in yield rate caused by dislocation in a single crystal and make the manufacture of a silicon single crystal highly efficient by suppressing deformation of the quartz glass crucible for pulling a silicon single crystal during a single crystal pulling process and a method of manufacturing the same quartz glass crucible.

In order to achieve the above-described object, according to the present invention there is provided a quartz glass crucible for pulling a silicon single crystal, comprising at least an outer layer portion being a translucent glass layer containing multiple bubbles in it and an inner layer portion being a transparent quartz glass layer having no bubbles and a smooth surface, formed on the inner surface of the outer layer portion, wherein the outer layer portion contains bubbles of 0.1 to 0.3 mm in diameter at the density of 1.5 to 5.0x10⁴ bubbles/cm³.

Since a quartz glass crucible for pulling a silicon single crystal, whose outer layer portion being a translucent glass layer containing bubbles of 0.1 to 0.3 mm in diameter at the density of 1.5 to 5.0x10⁴ bubbles/cm³ in such a way, has larger-sized bubbles contained in the outer layer portion of the translucent glass layer at a higher density than a quartz glass crucible molded by the prior art, the crucible expands more greatly in thickness at the time of melting polycrystalline silicon material inside the crucible and is more increased in mechanical strength (a conventional bubble density as described above is 1.0 to 1.4×10⁴ bubbles/cm³).
Here, it is possible to sufficiently improve a quartz glass crucible in mechanical strength by making it contain bubbles of 0.1 to 0.3 mm in diameter at the density of 1.5x10⁴ bubbles/cm³ or more and it is possible to prevent the surface of raw material silicon melt from rising too high due to a too great expansion in thickness of the crucible at the time of melting polycrystalline silicon material and reduce a harmful effect to the oxygen concentration in a silicon single crystal or a crystal defect control by keeping the bubble density not more than 5.0×10⁴ bubbles/cm³.

And according to the present invention, there is provided a quartz glass crucible for pulling a silicon single crystal, comprising at least an outer layer portion being a translucent glass layer containing multiple bubbles in it and an inner layer portion being a transparent quartz glass layer having no bubbles and a smooth surface, formed on the inner surface of the outer layer portion, wherein the outer layer portion is molded out of quartz powder having grain diameter of 160 µm to 360 µm mixed at the ratio of 80 weight% or more.

Since a quartz glass crucible molded out of quartz powder having grain diameter of 160 µm to 360 µm mixed at the ratio of 80 weight% or more, being larger in grain size than conventional quartz powder in such a way, has larger-sized bubbles formed in the outer layer portion being a translucent glass layer than a quartz glass crucible molded by the prior art, it is possible to more increase the quartz glass crucible in mechanical strength (in a conventional distribution of grain diameter, grain diameter of 160 µm to 360 µm occupy 70 weight%).

At this time, it is preferable that quartz powder for forming the outer layer portion is natural quartz powder.
Thanks to a fact that quartz powder used to mold the outer layer portion is natural quartz powder which can be obtained by pulverizing and then refining quartz naturally produced, it is possible to manufacture the outer layer portion being a translucent glass layer at low cost and easily by means of an arc heating rotation molding method.

Further, it is preferable that the inner layer portion is molded out of synthetic quartz powder.
Since an inner layer portion molded out of synthetic quartz powder in such a way is high in purity, it is possible to grow a silicon single crystal of a high quality required in manufacture of VLSI's in recent years. It is possible to use, for example, non-porous high-purity amorphous synthetic silica powder as synthetic quartz powder in this case.

And it is preferable that the quartz glass crucible is 700 mm or more in bore diameter.
Thanks to a fact that the quartz glass crucible is 700 mm or more in bore diameter, it is possible to cope with enlargement in diameter of a silicon single crystal with an increase in demand for silicon wafer in recent years and pull a large-diameter silicon single crystal of 300 mm or more in diameter for example. Since the quartz glass crucible can cope with enlargement in diameter of a silicon single crystal in the future, the larger the bore diameter of the quartz glass crucible is, the more effect it exhibits and therefore it is not possible to determine the upper limit in particular.

In addition, in case of melting polycrystalline silicon material in the quartz glass crucible to prepare raw material silicon melt, it is preferable that the thickness of a contact portion of the quartz glass crucible with the raw material silicon melt expands 1.2 to 2.0 times larger than the thickness before the raw material is melted.
While a silicon single crystal is being pulled from raw material silicon melt, particularly a contact portion of the quartz glass crucible with the silicon melt expands in thickness with expansion of bubbles existing in the outer layer portion of the quartz glass crucible. And in case of melting polycrystalline silicon material in the quartz glass crucible to prepare raw material silicon melt, thanks to a fact that the thickness of a contact portion of the quartz glass crucible with the raw material silicon melt expands 1.2 or more times larger than the thickness before the raw material is melted, it is possible to sufficiently improve the quartz glass crucible in mechanical strength. It is possible to prevent the surface of raw material silicon melt from rising too high and reduce a harmful effect to the oxygen concentration in a silicon single crystal or a crystal defect control by keeping the thickness in the contact portion not more than 2.0 times thickness before the raw material is melted.

And it is preferable that the thickness expands at the speed of 0.2 mm/h or higher from the time of coming into contact with the raw material silicon melt.
If it is possible to make the thickness of the quartz glass crucible in an area of the quartz glass crucible being in contact with raw material silicon melt expand at the speed of 0.2 mm/h or higher from the time of coming into contact with the silicon melt in such a way, it is possible to make the thickness expand to a desired thickness at an early stage of pulling a silicon single crystal from the beginning of heat-melting polycrystalline silicon by means of a heater, and therefore even in case of growing a silicon single crystal of 300 mm in diameter for example using a quartz glass crucible of 700 mm or more in bore diameter, a silicon single crystal can be stably manufactured due to a fact that the quartz glass crucible is not deformed during a silicon single crystal manufacturing process. However, since the surface of raw material silicon melt rises too high when the expansion speed of thickness is too fast, it is enough that the speed of expansion is about 0.8 mm/h.

In addition, according to the present invention, there is provided a method of manufacturing a silicon single crystal, characterized by manufacturing a silicon single crystal by means of Czochralski method using a quartz glass crucible for pulling a silicon single crystal as described above.
In such a way, according to the present invention, a silicon single crystal can be manufactured by Czochralski method using a quartz glass crucible as described above being increased in mechanical strength, and thereby it is possible to suppress deformation of a quartz glass crucible while a single crystal is being pulled, prevent degradation in yield rate due to dislocation in the single crystal and make the manufacture of a silicon single crystal highly efficient.

At this time it is preferable that the silicon single crystal to be manufactured is a silicon single crystal of 200 mm or more in diameter.
Even in case of growing a large-diameter silicon single crystal of 200 mm or more in diameter, or further of 300 mm or more in diameter in such a way, since a quartz glass crucible is not deformed during a silicon single crystal manufacturing process, it is possible to stably manufacture a silicon single crystal. The larger the diameter of a silicon single crystal as described above is, the more effective the present invention is, but since the diameter of it is made larger correspondingly to enlargement in diameter of a silicon single crystal in the future, the upper limit of it cannot be determined in particular.

Further, according to the present invention, there is provided a method of manufacturing a quartz glass crucible for pulling a silicon single crystal, comprising an outer layer portion being a translucent glass layer containing multiple bubbles in it and an inner layer portion being a transparent quartz glass layer having no bubbles and a smooth surface, formed on the inner surface of the outer layer portion, characterized by molding the outer layer portion out of quartz powder having grain diameter of 160 µm to 360 µm mixed at the ratio of 80 weight% or more by means of an arc discharge heating process.

Since a quartz glass crucible molded out of quartz powder having grain diameter of 160 µm to 360 µm mixed at the ratio of 80 weight% or more in such a way has larger-sized bubbles formed in the outer layer portion than a quartz glass crucible molded by the prior art, it is possible to more increase the quartz glass crucible in mechanical strength.

And it is preferable that natural quartz powder is used as quartz powder for molding the outer layer portion.
By using natural quartz powder which can be obtained by pulverizing and then refining quartz naturally produced as quartz powder for molding the outer layer portion, it is possible to manufacture the outer layer portion being a translucent glass layer at low cost and easily by means of an arc heating rotation molding method.

In addition, it is preferable that the inner layer portion is molded out of synthetic quartz powder.
By forming the inner layer portion out of synthetic quartz powder in such a way, it is possible to grow a silicon single crystal of a high purity required in manufacture of VLSI's in recent years. It is possible to use, for example, non-porous high-purity amorphous synthetic silica powder as synthetic quartz powder in this case.

And it is preferable to manufacture a quartz glass crucible of 700 mm or more in bore diameter as the quartz glass crucible.
By manufacturing a quartz glass crucible of 700 mm or more in bore diameter as a quartz glass crucible in such a way, it is possible to cope with enlargement in diameter of a silicon single crystal with an increase in demand for silicon wafer in recent years and pull a large-diameter silicon single crystal of 300 mm or more in diameter for example, at a high yield rate.

In such a way, according to the present invention, there is provided a quartz glass crucible increased in mechanical strength for pulling a silicon single crystal, and particularly it has been possible to suppress deformation of a quartz glass crucible while a large-diameter single crystal is being pulled, thereby prevent degradation in yield rate due to dislocation in a single crystal, and make the manufacture of a silicon single crystal highly efficient.

### BRIEF DESCRIPTION OF THE DRAWINGS

Fig. 1 is a schematic sectional view of a quartz glass crucible for pulling a silicon single crystal according to the present invention;
Fig. 2 is an explanatory diagram for a method of manufacturing a quartz glass crucible for pulling a silicon single crystal according to the present invention;
Fig. 3 is a graph showing the relation between the manufacturing time of a quartz glass crucible for pulling a silicon single crystal and the thickness of the quartz glass crucible according to the present invention;
Fig. 4 is sectional photographs of quartz glass crucible outer layer portions of the present invention ((A) Example 2) and a conventional example ((B) Comparative Example 2);
Fig. 5 is a graph showing a result of measuring the straight bodies in thickness of the quartz glass crucibles of the present invention ((A) Example 2) and the conventional example ((B) Comparative Example 2);
Fig. 6 is a graph showing the distribution of grain diameters in natural quartz powder used in molding of the outer layer portions of quartz glass crucibles of the present invention ((A) Example 1 and (B) Example 2) and the conventional example ((C) Comparative Example 1 and (D) Comparative Example 2); and
Fig. 7 is a schematic diagram showing an example of a single crystal manufacturing apparatus using a quartz glass crucible for pulling a silicon single crystal according to the present invention.

### BEST MODE FOR CARRYING OUT THE INVENTION

Since a thermal load applied to a quartz glass crucible has been increased at the time of melting polycrystalline silicon being a raw material with the increase in diameter of a silicon wafer in recent years, deformation of a quartz glass crucible during a silicon single crystal manufacturing process has been a great cause to hinder the growth of a silicon single crystal.

Thereupon, the present inventors have energetically studied and found that a quartz glass crucible for pulling a silicon single crystal, comprising at least an outer layer portion being a translucent glass layer containing multiple bubbles in it and an inner layer portion being a transparent quartz glass layer having no bubbles and a smooth surface, formed on the inner surface of the outer layer portion, wherein the outer layer portion contains bubbles of 0.1 to 0.3 mm in diameter at the density of 1.5 to 5.0×10⁴ bubbles/cm³ can be a quartz glass crucible increased in mechanical strength, suppress deformation of a quartz glass crucible being increased in bore diameter during a single crystal pulling process, thereby prevent degradation in yield rate due to dislocation in a single crystal, and make the manufacture of a silicon single crystal highly efficient.

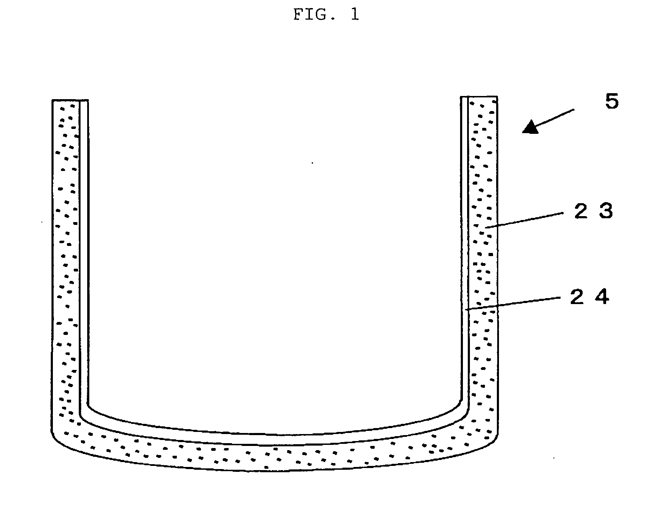

Although embodiments of the present invention are described in detail with reference to the drawings in the following, the present invention is not limited to these embodiments. Fig. 1 is an example of a schematic diagram of a quartz glass crucible for pulling a silicon single crystal according to the present invention.

The present invention is a quartz glass crucible 5 for pulling a silicon single crystal, comprising an outer layer portion 23 being a translucent glass layer containing multiple bubbles in it and an inner layer portion 24 being a transparent quartz glass layer having no bubbles and a smooth surface, formed on the inner surface of the outer layer portion 23, wherein the outer layer portion 23 contains bubbles of 0.1 to 0.3 mm in diameter at the density of 1.5 to 5.0x10⁴ bubbles/cm³.

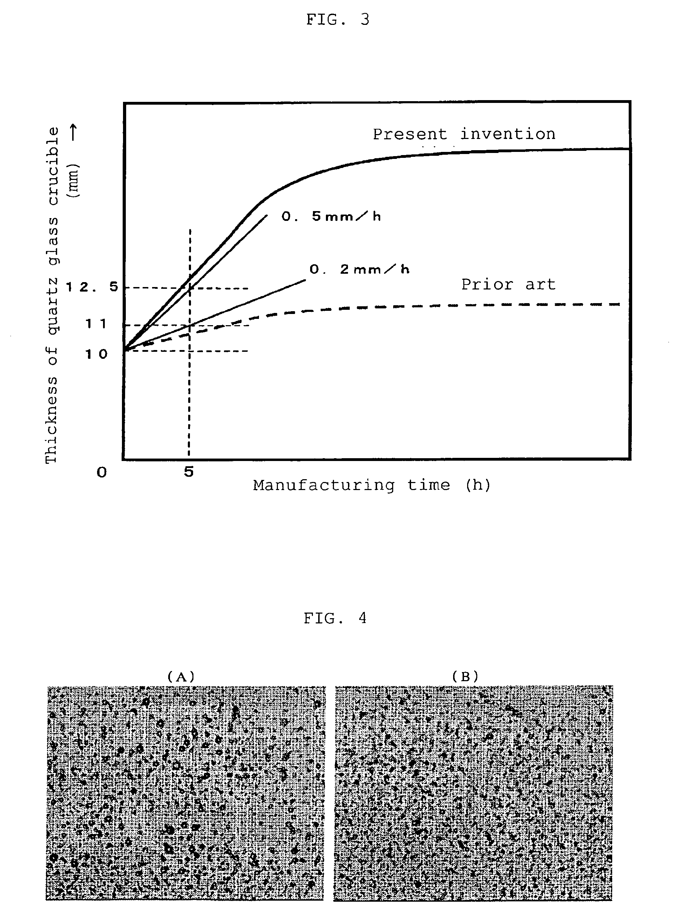

As shown in a sectional photograph of an outer layer portion in Fig. 4(A), a quartz glass crucible 5 for pulling a silicon single crystal, having an outer layer portion 23 containing bubbles of 0.1 to 0.3 mm in diameter at the density of 1.5 to 5.0×10⁴ bubbles/cm³ in such a way has larger-sized bubbles contained at a higher density in the outer layer portion being a translucent glass layer than a quartz glass crucible molded by the prior art shown in Fig. 4(B) and is increased in mechanical strength thanks to a fact that the thickness of the crucible expands greatly at the time of melting polycrystalline silicon material in the crucible.

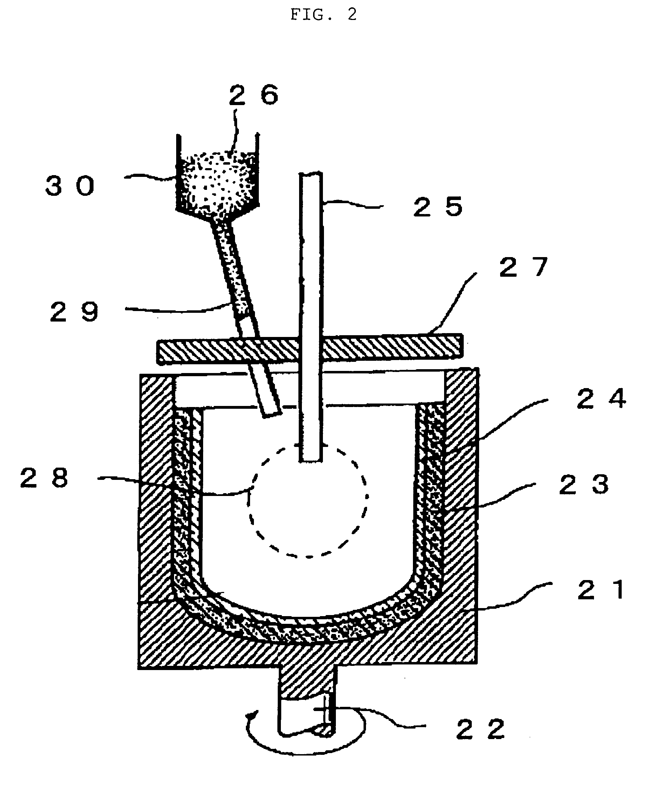

In order to manufacture such a quartz glass crucible 5 according to the present invention, as shown in Fig. 2 firstly an outer layer portion 23 is made by supplying natural quartz powder made up so that grain diameter of 160 µm to 360 µm occupy 80 weight% or more in the distribution grain diameter into a rotation mold 21 rotated by a rotating shaft 22, preliminarily molding the natural quartz powder into a desired shape, melting this preliminarily molded powder by heating it from the inside with a carbon electrode 25, and cooling it.

By doing this, an outer layer portion 23 of a quartz glass crucible 5, the outer layer portion containing multiple bubbles in it and being translucent in appearance can be molded. In this case, since the natural quartz powder is larger in grain diameter than conventional quartz powder, the bubbles existing in the outer layer portion 23 are larger in size than conventional bubbles.

Next, in a high temperature gas atmosphere 28 prepared by an arc discharge, non-porous high-purity amorphous synthetic silica powder filled in a hopper 30 as quartz powder 26 is supplied onto the inner surface of the molded outer layer portion 23 by opening a nozzle 29 as adjusting the amount of powder supplied. At least a part of this silica powder is melted and scattered by an arc discharge toward the inner surface of the crucible 23 and adheres to the inner surface of the outer layer portion 23 being in a melted or softened state. By this adhesive layer-building, a transparent inner layer portion 24 having no bubbles is molded into a prescribed thickness in one body on the outer layer portion 23 being a multi-bubble layer.

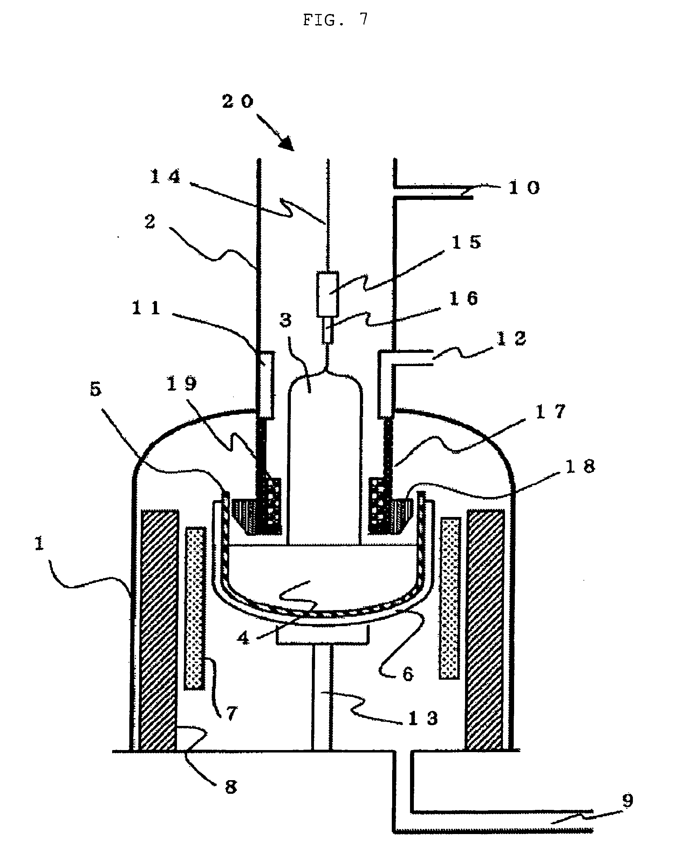

A quartz glass crucible 5 whose inner layer portion 24 includes a transparent layer having no bubbles in such a way plays a role of preventing gas inside a bubble existing in the outer layer portion 23 from entering a silicon melt during a process of pulling a silicon single crystal 3 as shown in Fig. 7, and as a result, the crucible makes it possible to prevent bubbles from being taken into the silicon single crystal 3 to form such defects as pinholes and the like.

By manufacturing a quartz glass crucible of 700 mm or more in bore diameter as such a quartz glass crucible 5, it is possible to cope with enlargement in diameter of a silicon single crystal 3 with an increase in demand for silicon wafers in recent years, and it is possible to pull a large-diameter silicon single crystal 3 of 300 mm or more in diameter for example.

And at the time of pulling a silicon single crystal 3 from melt of polycrystalline silicon material, particularly a contact portion of a quartz glass crucible 5 with the silicon melt expands in thickness with expansion of bubbles existing in the outer layer portion 23 of the quartz glass crucible 5 (see Fig. 3). And in case of preparing a raw material silicon melt 4 by melting polycrystalline silicon material inside the quartz glass crucible 5, it is preferable that the thickness of a contact portion of the quartz glass crucible 5 with the raw material silicon melt 4 expands 1.2 or more times thicker than the thickness before the raw material is melted. Due to this, the mechanical strength of the quartz glass crucible 5 can be made sufficiently high. And it is preferable that the thickness is made 2.0 or less times the thickness before the raw material is melted, and thereby it is possible to prevent the surface of the raw material silicon melt from rising too high and reduce a harmful effect to control the oxygen concentration or a crystal defect in a silicon single crystal 3.

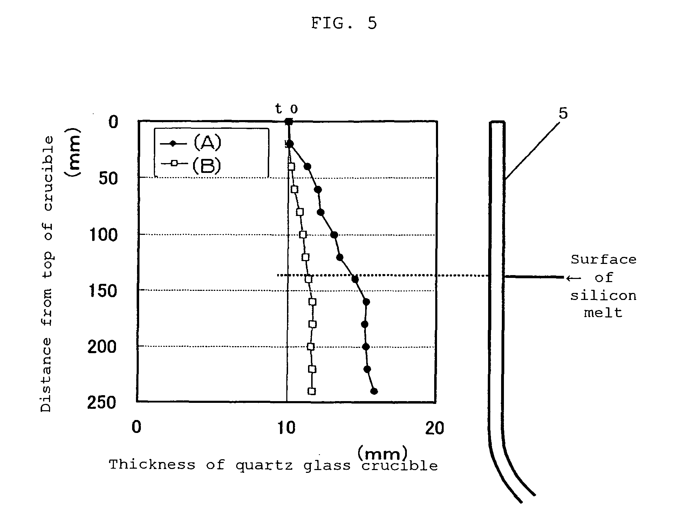

That is to say, in case of assuming that the thickness of a quartz glass crucible 5 at the normal temperature before polycrystalline silicon material is melted is t0 (10 mm in Fig. 5) and the thickness of the quartz glass crucible 5 in an area being in contact with a raw material silicon melt 4 directly after the silicon single crystal 3 has been pulled (area being 140 mm or more distant from the top of the crucible in Fig. 5) is t1, it is preferable that the thickness of the quartz glass crucible 5 expands within the range of 1.2<t1/t0<2.0 in the rate of expansion as shown in Fig. 5(A). It is considered that the rate of expansion of the thickness of a quartz glass crucible 5 depends on the density of large bubbles in the outer layer portion 23 of the quartz glass crucible 5 at the normal temperature before the polycrystalline silicon material is melted and if this density is large it is possible to make the rate of expansion large.
And due to this, since it is possible to design a quartz glass crucible 5 at the minimum thickness, the amount of natural quartz powder used in molding a large-bore diameter quartz glass crucible 5 can be remarkably reduced and this is very effective to reduce the manufacturing cost of a large-bore diameter quartz glass crucible 5.

And it is preferable that a quartz glass crucible 5 can make the thickness of the quartz glass in an area of the quartz glass crucible being in contact with raw material silicon melt 4 expand at the speed of 0.2 mm/h or higher, more preferably 0.5 mm/h or higher during the growth of a silicon single crystal 3 (see slopes in Fig. 3) . Even in case of growing a silicon single crystal of 300 mm in diameter using a quartz glass crucible 5 of 700 mm or further 800 mm (32 inches) or more in bore diameter, the quartz glass crucible 5 being a quartz glass crucible which can make its thickness expand to a desired thickness at an early stage of pulling the silicon single crystal 3 from the beginning of heat-melting polycrystalline silicon by means of a heater 7 in such a way, the quartz glass crucible 5 is not deformed during a process of manufacturing the silicon single crystal 3 and therefore the silicon single crystal 3 can be stably manufactured and thereby the percentage of success in single-crystallization of a silicon single crystal 3 can be improved and the improvement in yield rate can be realized.

A quartz glass crucible 5 for pulling a silicon single crystal according to the present invention as described above is protected by a graphite crucible 6 in a single crystal manufacturing apparatus 20 as shown in Fig. 7 for example and is supported in a support axis 13 rotatably and movably upward and downward by a crucible driving mechanism (not illustrated) in a main chamber 1. And polycrystalline silicon material is melted by a heater 7 to form a raw material silicon melt 4 in a quartz glass crucible 5 for pulling a silicon single crystal, a seed crystal 16 held by a seed holder 15 is brought into contact with the raw material silicon melt 4 and then is pulled up as being rotated by wire 14, and thereby a silicon single crystal 3 is grown. And the silicon single crystal 3 grown is put in a pulling chamber 2 coupled with the main chamber 1 and taken out.

A gas flow-guide cylinder 17 formed out of graphite material is disposed inside the main chamber 1 so as to surround the silicon single crystal 3 grown and can regulate an inert gas flow of Ar or the like introduced from a gas intake 10 provided in the upper part of the pulling chamber 2 at the time of pulling the single crystal, and can make the gas flow pass through between a heat insulating member 18 and the surface of the silicon melt 4 to discharge it through a gas outlet 9.

Heat insulating members 18 and 19 are provided inside and outside the lower end of the gas flow-guide cylinder 17 for keeping hot the surface of the raw material silicon melt 4 as well as cutting off radiation from the surface of the raw material silicon melt 4. The heat insulating members 18 and 19 can use graphite, molybdenum, tungsten, silicon carbide, or graphite the surface of which is coated with silicon carbide, may hold a heat insulating member inside it, and their shape and size are not limited in particular but may be properly changed according to need.
A cooling cylinder 11 being different in material from the gas flow-guide cylinder 17 is installed above the gas flow-guide cylinder 17 and is made so as to be able to forcedly cool the silicon single crystal 3 by making a cooling medium flow through a cooling medium intake 12. The cooling cylinder 11 does not necessarily need to be installed but may be omitted according to purpose, and for example the silicon single crystal 3 may be forcedly cooled by making a cooling medium flow through the gas flow-guide cylinder 17.
And a radiant heat radiated from the heater 7 directly to the main chamber 1 is shut off by providing a heat insulating member 8.

Since a quartz glass crucible for pulling a silicon single crystal according to the present invention, the quartz glass crucible being increased in mechanical strength, is used in such a silicon single crystal pulling process, even in case of growing a large-diameter silicon single crystal of 200 mm or more, or further 300 mm in diameter, the resistance to an increased thermal load is made higher thanks to the increased mechanical strength, and it has been possible to suppress deformation of a quartz glass crucible during a single crystal pulling process and thereby prevent degradation in yield rate due to dislocation in a single crystal and make the manufacture of a silicon single crystal highly efficient.

Although the present invention is described in more detail as showing examples and comparative examples in the following, the present invention is not limited to them.

### (Example 1)

Eleven quartz glass crucibles of 800 mm in bore diameter and 10 mm in thickness (t0) each having an outer layer portion molded out of natural quartz powder having grain diameter of 160 µm to 360 µm at the ratio of 85 weight% and grain diameter of 160 µm or less at the ratio of 15 weight% mixed with each other and thereafter having an inner layer portion molded out of non-porous high-purity amorphous synthetic quartz powder on the surface of the outer layer portion were manufactured and one out of them was used for evaluating bubbles contained in the outer layer portion.
And when bubbles contained in the outer layer portion were evaluated by microscope-observing a section of the quartz crucible, it was found that it contained bubbles of 0.1 to 0.3 mm in diameter at the density of 3.4x10⁴/cm³.

Next, each of quartz glass crucibles manufactured was charged with 340 kg of polycrystalline silicon and a single crystal of 300 mm in diameter and of <100> in crystal orientation was pulled up by a single crystal manufacturing apparatus of Fig. 7. A manufacturing time of each single crystal was 130 hours.
As a result, the percentage of success in single-crystallization was 100%. And when each quartz glass crucible after being used was observed, no deformation of each quartz glass crucible was found and the thickness t1 of a straight body in an area having been in contact with a raw material silicon melt was 14 mm and the rate of expansion t1/t0 was 1.4. A criterion of judging whether or not a quartz glass crucible had deformed at that time was determined to be the case that the straight body of a quartz glass crucible fell into the silicon melt side and deformed by 5% or more in bore diameter from that at the normal temperature before being used, or the case that the quartz glass crucible was buckled.

### (Example 2)

Eleven quartz glass crucibles of 800 mm in bore diameter and 10 mm in thickness (t0) each having an outer layer portion molded out of natural quartz powder having grain diameter of 160 µm to 360 µm at the ratio of 95 weight% and grain diameter of 160 µm or less at the ratio of 5 weight% mixed with each other and thereafter having an inner layer portion molded out of non-porous high-purity amorphous synthetic quartz powder on the surface of the outer layer portion were manufactured and one out of them was used for observing a section of the outer layer portion and evaluating bubbles contained in the outer layer portion.
And when bubbles contained in the outer layer portion were evaluated by microscope-observing a section of the quartz crucible, it was found that it contained bubbles of 0.1 to 0.3 mm in diameter at the density of 4.8x10⁴/cm³.

Next, as a result of pulling each of single crystals in the same manner as Example 1 using the quartz glass crucible manufactured, the percentage of success in single-crystallization was 100%. And when each quartz glass crucible after being used was observed, no deformation of the quartz glass crucibles was found and the thickness t1 of a straight body in an area having been in contact with a raw material silicon melt was 16 mm and the rate of expansion t1/t0 was 1.6. In the outer layer portions there were many bubbles being larger in size than conventional bubbles, as shown in a sectional photograph of Fig. 4(A).

### (Example 3)

Eleven quartz glass crucibles of 800 mm in bore diameter and 10 mm in thickness (t0) each having an outer layer portion molded out of natural quartz powder having grain diameter of 160 µm to 360 µm at the ratio of 80 weight% and grain diameter of 160 µm or less at the ratio of 20 weight% mixed with each other and thereafter having an inner layer portion molded out of non-porous high-purity amorphous synthetic quartz powder on the surface of the outer layer portion were manufactured and one out of them was used for evaluating bubbles contained in the outer layer portion.
And when bubbles contained in the outer layer portion were evaluated by microscope-observing a section of the quartz glass crucible, it was found that it contained bubbles of 0.1 to 0.3 mm in diameter at the density of 2.0×10⁴/cm³.

Next, as a result of pulling each of single crystals in the same manner as Example 1 using the quartz glass crucible manufactured, the percentage of success in single-crystallization was 100%. And when each quartz glass crucible after being used was observed, no deformation of the quartz glass crucibles was found and the thickness t1 of a straight body in an area having been in contact with a raw material silicon melt was 12.5 mm and the rate of expansion t1/t0 was 1.25.

### (Comparative Example 1)

Eleven quartz glass crucibles of 800 mm in bore diameter and 10 mm in thickness (t0) each having an outer layer portion molded out of natural quartz powder having grain diameter of 160 µm to 360 µm at the ratio of 70 weight% and grain diameter of 160 µm or less at the ratio of 30 weight% mixed with each other and thereafter having an inner layer portion molded out of non-porous high-purity amorphous synthetic quartz powder on the surface of the outer layer portion were manufactured and one out of them was used for observing a section of the outer layer portion and evaluating bubbles contained in the outer layer portion.
And when bubbles contained in the outer layer portion were evaluated by microscope-observing a section of the quartz crucible, it was found that it contained bubbles of 0.1 to 0.3 mm in diameter at the density of 1.4×10⁴/cm³.

Next, as a result of pulling each of single crystals in the same manner as Example 1 using the quartz glass crucible manufactured, the percentage of success in single-crystallization was 80%. And when each quartz glass crucible after being used was observed, deformation of the quartz glass crucibles occurred at the ratio of 10% and the thickness t1 of a straight body in an area having been in contact with a raw material silicon melt was 11.8 mm and the rate of expansion t1/t0 was 1.18. In the outer layer portions there were hardly bubbles being large in size, as shown in a sectional photograph of Fig. 4(B).

### (Comparative Example 2)

Eleven quartz glass crucibles of 800 mm in bore diameter and 10 mm in thickness (t0) each having an outer layer portion molded out of natural quartz powder having grain diameter of 160 µm to 360 µm at the ratio of 30 weight% and grain diameter of 160 µm or less at the ratio of 70 weight% mixed with each other and thereafter having an inner layer portion molded out of non-porous high-purity amorphous synthetic quartz powder on the surface of the outer layer portion were manufactured and one out of them was used for evaluating bubbles contained in the outer layer portion.
And when bubbles contained in the outer layer portion were evaluated by microscope-observing a section of the quartz crucible, it was found that it contained bubbles of 0.1 to 0.3 mm in diameter at the density of 1.0×10⁴/cm³.

Next, as a result of pulling each of single crystals in the same manner as Example 1 using the quartz glass crucible manufactured, the percentage of success in single-crystallization was 50%. And when each quartz glass crucible after being used was observed, deformation of the quartz glass crucibles occurred at the ratio of 30% and the thickness t1 of a straight body in an area having been in contact with a raw material silicon melt was 11 mm and the rate of expansion t1/t0 was 1.1.

### (Comparative Example 3)

Eleven quartz glass crucibles of 800 mm in bore diameter and 10 mm in thickness (t0) each having an outer layer portion molded out of natural quartz powder having grain diameter of 160 µm to 360 µm at the ratio of 50 weight% and grain diameter of 160 µm or less at the ratio of 50 weight% mixed with each other and thereafter having an inner layer portion molded out of non-porous high-purity amorphous synthetic quartz powder on the surface of the outer layer portion were manufactured and one out of them was used for evaluating bubbles contained in the outer layer portion.
And when bubbles contained in the outer layer portion were evaluated by microscope-observing a section of the quartz crucible, it was found that it contained bubbles of 0.1 to 0.3 mm in diameter at the density of 1.2x10⁴/cm³.

Next, as a result of pulling each of single crystals in the same manner as Example 1 using the quartz glass crucible manufactured, the percentage of success in single-crystallization was 60%. And when each quartz glass crucible after being used was observed, deformation of the quartz glass crucibles occurred at the ratio of 20% and the thickness t1 of a straight body in an area having been in contact with a raw material silicon melt was 11.4 mm and the rate of expansion t1/t0 was 1.14.

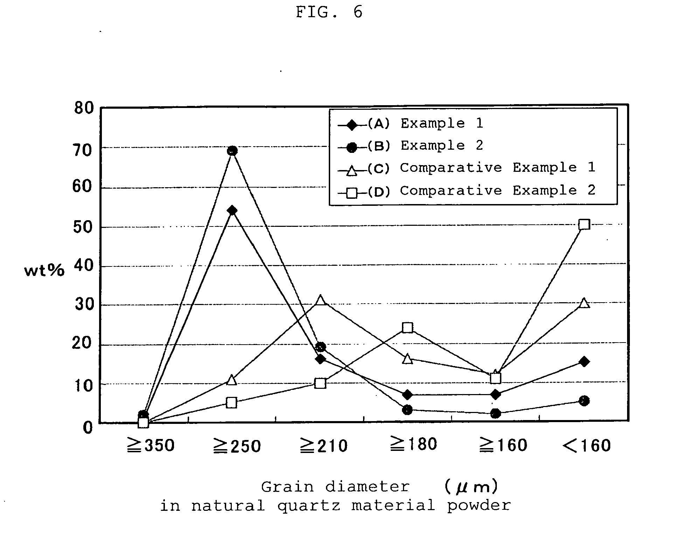

The result of evaluation of Examples 1, 2 and 3 and Comparative Examples 1, 2 and 3 is shown in the following Table 1. And the distributions of grain diameters in natural quartz powder used in molding the outer layer portions of the quartz glass crucibles of Examples 1 and 2 and Comparative Examples 1 and 2 are shown in (A) to (D) of Fig. 6.

**[Table 1]**

| | Bubble density x10⁴ bubbles /cm³ | Mixture ratio in natural quartz powder | | Rate of expansion in thickness of straight body t1/t0 | Rate of occurrence of deformation | Percentage of success in single-crystallization |
|---|---|---|---|---|---|---|
| | | 160 ∼ 360 µm | < 160 µm | | | |
| Example 1 | 3.4 | 85% | 15% | 1.4 | 0% | 100% |
| Example 2 | 4.8 | 95% | 5% | 1.6 | 0% | 100% |
| Example 3 | 2.0 | 80% | 20% | 1.25 | 0% | 100% |
| Comparative Example 1 | 1.4 | 70% | 30% | 1.18 | 10% | 80% |
| Comparative Example 2 | 1.0 | 30% | 70% | 1.1 | 30% | 50% |
| Comparative Example 3 | 1.2 | 50% | 50% | 1.14 | 20% | 60% |

As shown in Table 1, even in case of manufacturing a single crystal of 300 mm in diameter, if a silicon single crystal is manufactured using a quartz glass crucible having an outer layer portion molded out of natural quartz powder having grain diameter of 160 µm to 360 µm at the ratio of 80 weight% or more mixed, the rate of expansion t1/t0 in thickness of the quartz glass crucible in an area having been in contact with a raw material silicon melt after being used exceeds 1.2 and no deformation of the quartz glass crucible occurs. As a result, the percentage of success in single-crystallization can be made to be 100%, and a very stable manufacture of a silicon single crystal can be realized.

The present invention is not limited to the embodiments described above. The above-described embodiments are only examples and any means having substantially the same composition as the technical ideas defined in the claims of the present invention and exhibiting similar effects to them is included within the technical range of the present invention.

## Claims

1. A quartz glass crucible for pulling a silicon single crystal, comprising at least an outer layer portion being a translucent glass layer containing multiple bubbles in it and an inner layer portion being a transparent quartz glass layer having no bubbles and a smooth surface, formed on the inner surface of the outer layer portion, wherein the outer layer portion contains bubbles of 0.1 to 0.3 mm in diameter at the density of 1.5 to 5.0x10⁴ bubbles/cm³.

2. A quartz glass crucible for pulling a silicon single crystal, comprising at least an outer layer portion being a translucent glass layer containing multiple bubbles in it and an inner layer portion being a transparent quartz glass layer having no bubbles and a smooth surface, formed on the inner surface of the outer layer portion, wherein the outer layer portion is molded out of quartz powder having grain diameter of 160 µm to 360 µm at the ratio of 80 weight% or more mixed.

3. A quartz glass crucible for pulling a silicon single crystal according to claim 1 or 2, wherein quartz powder for forming the outer layer portion is natural quartz powder.

4. A quartz glass crucible for pulling a silicon single crystal according to any one of claims 1 to 3, wherein the inner layer portion is molded out of synthetic quartz powder.

5. A quartz glass crucible for pulling a silicon single crystal according to any one of claims 1 to 4, wherein the quartz glass crucible is 700 mm or more in bore diameter.

6. A quartz glass crucible for pulling a silicon single crystal according to any one of claims 1 to 5, wherein in case of using raw material silicon melt obtained by melting polycrystalline silicon material in the quartz glass crucible, the thickness of a contact portion of the quartz glass crucible with the raw material silicon melt expands 1.2 to 2.0 times thicker than the thickness of it before the polycrystalline silicon material is melted.

7. A quartz glass crucible for pulling a silicon single crystal according to any one of claims 1 to 6, wherein the thickness expands at the speed of 0.2 mm/h or higher from the time of coming into contact with the raw material silicon melt.

8. A silicon single crystal manufacturing method, **characterized by** manufacturing a silicon single crystal by Czochralski method, using a quartz glass crucible for pulling a silicon single crystal according to any one of claims 1 to 7.

9. A silicon single crystal manufacturing method according to claim 8, wherein the silicon single crystal manufactured is a silicon single crystal of 200 mm or more in diameter.

10. A method of manufacturing a quartz glass crucible for pulling a silicon single crystal, comprising an outer layer portion being a translucent glass layer containing multiple bubbles in it and an inner layer portion of a transparent quartz glass layer having no bubbles and a smooth surface, formed on the inner surface of the outer layer portion, **characterized by** molding at least the outer layer portion out of quartz powder having grain diameter of 160 µm to 360 µm mixed at the ratio of 80 weight% or more by means of an arc discharge heating process.

11. A method of manufacturing a quartz glass crucible for pulling a silicon single crystal according to claim 10, **characterized by** using natural quartz powder as quartz powder for molding the outer layer portion.

12. A method of manufacturing a quartz glass crucible for pulling a silicon single crystal according to claim 10 or 11, **characterized by** molding the inner layer portion out of synthetic quartz powder.

13. A method of manufacturing a quartz glass crucible for pulling a silicon single crystal according to any one of claims 10 to 12, **characterized by** manufacturing a quartz glass crucible of 700 mm or more in bore diameter as the quartz glass crucible.
